Europäisches Patentamt

**European Patent Office**

**Office européen des brevets**

(19)

(11) Publication number: **0 173 448**
A2

# (12) EUROPEAN PATENT APPLICATION

(21) Application number: **85305235.5**

(22) Date of filing: **23.07.85**

(51) Int. Cl.⁴: **C 30 B 23/02**, C 30 B 25/02, C 30 B 29/40

(30) Priority: **02.08.84 US 637155**

(43) Date of publication of application: **05.03.86** Bulletin 86/10

(84) Designated Contracting States: **DE FR GB**

(71) Applicant: **VARIAN ASSOCIATES, INC., 611 Hansen Way, Palo Alto, CA 94303 (US)**

(72) Inventor: **Chai, Young Gui, 4961 Rice Drive, San Jose California (US)**

(74) Representative: **Cline, Roger Ledlie et al, STANLEY, POPPLEWELL, POOLE 57 Lincoln's Inn Fields, London WC2A 3LS (GB)**

(54) **Method of forming a III-V semiconductor layer.**

(57) A molecular beam comprising at least one group III element is directed at a semiconductor body within an evacuated chamber. Simultaneously, a molecular beam comprising at least one group V element is directed at the semiconductor body to form a group III-V semiconductor layer, the or a group V molecular beam being formed by decomposing a compound of tin and phosphorus with heat. The invention includes apparatus for forming such a layer, including means for forming a group III molecular beam 14, 15 and means for decomposing tin and phosphorus to form a group V molecular beam 20 and 22, both means being within an evacuable chamber 11.

EP 0 173 448 A2

0173448

## Method of Forming a III-V Semiconductor Layer

This invention pertains to the use of phosphorus beams in a molecular beam epitaxial process.

One of the areas in which the molecular beam epitaxial (MBE) technique has been used successfully is in the manufacture of GaAs microwave devices. Good layer thickness and impurity level doping control, along with good lateral uniformity across the wafer, have made MBE a valuable and economical technique to grow field-effect transistors (FETs), IMPATT diodes, etc. See T.L. Hierl and P.E. Luscher, 2nd International Symposium on MBE and Related Clean Surface Techniques, Tokyo, August 1982, p. 147. In regard to the diodes, there is evidence that IMPATT diodes will operate at a higher frequency with less noise and with a higher efficiency if InP is used. See D. Lippens, E. Constant, M.R. Friscourt, P.A. Rolland and G. Salmer, IEEE Elect. Dev. Lett. EDL-3, 213 (1982). However, in order to grow InP with MBE, it is necessary to generate phosphorus beams, which involves more difficulties than generating arsenic beams because of the high vapor pressure of the phosphorus.

There are three methods in use for generating phosphorus molecular beams. One method is the use of elemental phosphorus, which is the most straightforward. When heated, elemental red phosphorus turns into $P_4$ vapor, providing the necessary phosphorus beam. See J.H. McFee, B.I. Miller and K.J. Bachmann, J. Electrochem. Soc. 124, 259 (1974).

High-purity red phosphorus is available, and InP layers grown using elemental red phosphorus show low background doping concentrations and high mobilities. See Y. Kawamura, M. Ikedo, H. Asashi and H. Okamoto, Appl. Phys. Lett. $\underline{35}$, 481 (1979) and J.S. Roberts, P. Dawson and G.B. Scott, Appl. Phys. Lett. $\underline{38}$, 905 (1981). The disadvantage of red phosphorus, however, is that the vapor condenses as white phosphorus, which has a very high vapor pressure, even at room temperature. Also, white phosphorus is inflammable and may cause fire when the system is opened to the atmosphere. Therefore, modification of the growth system is required to remove white phosphorus from the growth chamber during and after growth. See W.T. Tsang, R.C. Miller, F. Capasso and W.A. Bonner, Appl. Phys. Lett. $\underline{41}$, 467 (1982).

A second method is using $PH_3$ as a phosphorus source. See M.B. Panish, J. Electrochem. Soc. $\underline{127}$, 2729 (1980), and U.S. Patent No. 4,330,360 to Kubiak et al. As recent experiments show, $PH_3$ cracks into phosphorus and hydrogen when passed through a cracking zone at a temperature above 700°C, generating $P_2$ and hydrogen. See R. Chow and Y.G. Chai, J. Vac. Sci. Technol. $\underline{A1}$, 49 (1983). The $P_2$ condenses as red or black phosphorus which is stable at room temperature. Since $PH_3$ is stored in a gas cylinder outside the vacuum, the system need not be opened for refilling as with a solid source. However, one problem associated with $PH_3$ is disposal of the hydrogen. In spite of the reported benefits of hydrogen for MBE GaAs, (see A.R. Calawa, Appl. Phys. Lett. $\underline{38}$, 701 (1981), too much hydrogen in the system can significantly shorten the life of an ion pump by saturating the pumping element. One way to avoid this is to use a titanium sublimation pump (TSP). However, successful pumping of $H_2$ with a TSP requires multiple titanium sources and an efficient cooling system.

A more serious problem is the handling of $PH_3$. It is highly toxic and as little as 0.3 ppm can cause severe symptoms. Therefore, all tubing must be absolutely leak tight and continually monitored for safety.

A third method is the use of InP itself as a phosphorus beam source. See R.F.C. Farrow, J. Phys. D7, L121 (1974). When heated to about 300°C, phosphorus preferentially evaporates from InP, providing the necessary phosphorus beam. Theoretically the phosphorus beam from InP is dominantly dimer ($P_2$). See M.B. Panish and J.R. Arthur, J. Chem. Thermodynamics 2, 299 (1970). However, at higher temperatures, the phosphorus beam from InP becomes more $P_4$ rich. Also, at higher temperatures In evaporates from InP, affecting the growth rate.

According to the invention there is provided a method for forming a III-V semiconductor layer as set out in cIaim 1 or claim 6 of the claims of this specification. According to another aspect of the invention there is provided apparatus for forming a III-V semiconductor layer as set out in claim 2 of the claims of this specification.

These and further constructional and operational characteristics of the invention will be more evident from the detailed description given hereinafter with reference to the figures of the accompanying drawings which illustrate preferred embodiments and alternatives by way of non-limiting examples, and in which:-

FIG. 1 shows calculated and measured vapor pressures versus reciprocal temperatures for various melts.

FIG. 2 shows the mass spectrum of Sn-P at $T=350°C$.

FIG. 3 shows the partial pressure of P, $P_2$ and $P_4$ as a function of Sn-P furnace temperature.

FIG. 4 illustrates the molecular beam apparatus in accordance with the invention.

A tin melt saturated with phosphorus has been used to preserve the InP substrate surface during liquid phase epitaxy. See G.A. Antypas, Appl. Phys. Lett. 37, 64 (1980); and US - A 4,227,962 to Antypas. The rationale is that Sn as a solvent has a higher solubility than In for phosphorus; thus, even though the partial vapor pressure of phosphorus is higher at the same temperature, the phosphorus-saturated Sn melt overlayer can protect the InP substrate from phosphorus depletion at a growth temperature.

The same principle can also be applied to generating a phosphorus beam of improved purity in the MBE process. For example, the higher solubility of phosphorus in a tin melt allows operating the phosphorus source at a lower temperature, resulting in lower co-evaporation of the other constituent. As the following analysis will show, this is indeed the case for tin phosphide. The partial vapor pressures of $P_2$ and $P_4$ over tin phosphide are not known; however, approximate values can be calculated from the solubility data of phosphorus in a tin melt by assuming that phosphorus-saturated tin melt behaves similarly to that of the phosphorus-saturated In melt. For the first-order approximation, the partial vapor pressure of $P_2$ can be expressed as

$$P(P_2) = x^2 P^*(P_2)$$

where x is the mole fraction of phosphorus in solvent and $P^*(P_2)$ is the vapor pressure of $P_2$ in equilibrium with pure liquid phosphorus.

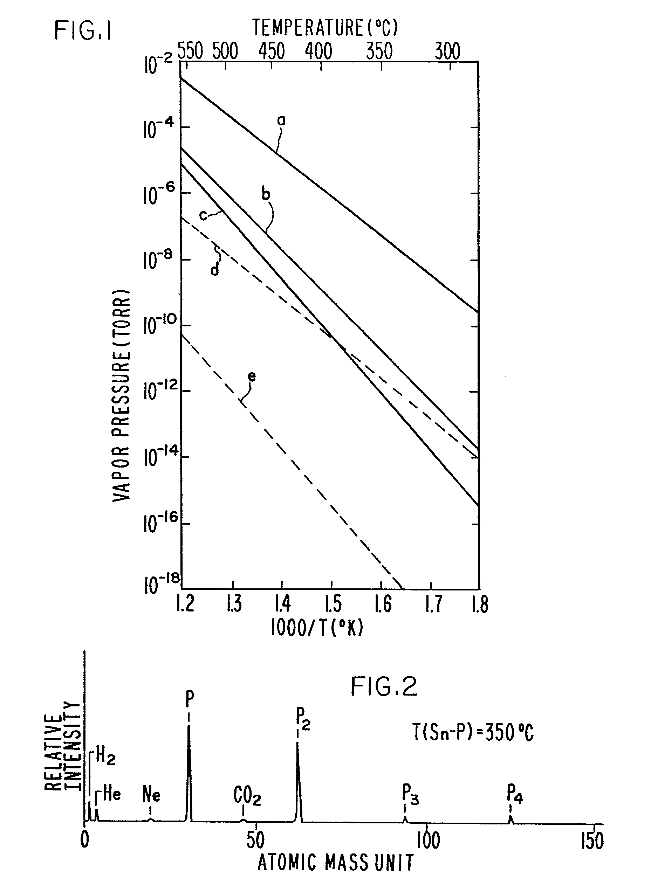

The curve in FIG. 1(c) shows the calculated vapor pressure of $P_2$ from an In melt saturated with InP according to the above equation. The solubility data of InP in the In melt is obtained from E. Buehler and K.J. Bachmann, J. Crys. Growth 35, 60 (1976) and $P^*$ from M.B. Panish, J. Crys. Growth 27, 6 (1974). Table I shows the thermodynamic functions used in the calculation. This curve is compared to the measured vapor pressure of $P_2$ from an In melt, FIG. 1(b). The difference between these two curves is the error caused by the ideal solution assumption in the above equation. As can be seen, the calculation underestimates the actual pressure by a factor of two or less.

The same calculation using the solubility data of InP in Sn gives the curve in FIG. 1(a). The comparison of curve (a) and (c) shows that the $P_2$ pressure from the Sn melt is two orders of magnitude or more higher than that from the In melt. Therefore, an Sn-P system can be operated at a lower temperature than an In-P system to generate the

same amount of $P_2$ beam.  For example, in order to generate $1 \times 10^{-5}$ Torr of $P_2$ beam, the temperature of the In-P melt should be about 550°C, whereas only 430°C is necessary for the Sn-P melt to obtain the same $P_2$ pressure.  At a temperature where the $P_2$ vapor pressure is $10^{-5}$ Torr, the vapor pressure of In from the In-P melt is about $10^{-7}$ Torr, whereas the vapor pressure of Sn from the Sn-P melt is only $10^{-14}$.  This means that the co-evaporation of Sn is negligible for the Sn-P system compared to the co-evaporation of In from the In-P system.  Also, it should be noted that the actual vapor pressure is higher than the theoretical calculation based on the ideal solution assumption, and the Sn-P melt can be operated at a still lower temperature, further reducing co-evaporation of Sn.  FIG. 1(d) shows the measured vapor pressure of indium, and FIG. 1(e) shows the measured vapor pressure of tin for reference.

## TABLE I: THERMODYNAMIC FUNCTIONS

Solubility of InP in In:  $\log_e x = -\dfrac{23.650(kcal/mole)}{RT} + 7.975 \quad (a)$

Solubility of InP in Sn:  $\log_e x = -\dfrac{11.034(kcal/mole)}{RT} + 3.303 \quad (a)$

Phosphorus reference: pressure  $\log_{10} P([P_2]/atm) = -\dfrac{7175}{T} + 6.205 \quad (b)$

$P_2$ vapor pressure from: InP melt  $\log_{10} P([P_2]/atm) = -\dfrac{15480}{T} + 11.129 \quad (b)$

Pure In vapor pressure:  $\log_{10} P(mmHg) = -\dfrac{12580}{T} - 0.45 \log T + 9.79 \quad (c)$

Pure Sn vapor pressure:  $\log_{10} P(mmHg) = -\dfrac{15500}{T} + 8.23 \quad (c)$

(a)  E. Buehler and K.J. Bachmann, supra

(b)  M.B. Panish, supra

(c)  O. Kubaschewski and C.B. Alcook, Metallurgical Thermochemistry (Pergamon Press, 1979)

Tin phosphide used in the method can be synthesized in a vacuum-sealed quartz ampoule by heating tin and phosphorus to 400°C (in a pressure chamber) and slowly cooling to room temperature. The amount of tin and phosphorus in the ampoule was such that the molecular weight ratio was close to the stoichiometry of the most stable tin phosphide ($Sn_3P_4$), but with an additional 10% tin to give an Sn-rich source. SnP and $SnP_3$ may also be used. The synthesized tin phosphide contained Sn droplets, indicating that it was indeed Sn-rich. The partial vapor pressure from this tin phosphide source was measured as a function of the source temperature using quadrupole mass spectrum analyzer (QMA) in an ultra-high vacuum chamber. A graphite crucible was used to hold the tin phosphide; the volume of tin phosphide used was approximately 50 ml.

A typical spectrum is shown in FIG. 2 which was taken at a furnace temperature of 350°C. As shown in the figure, the mass spectrum is dominated by $P_2$; the $P_4$ peak is an order of magnitude smaller. A high peak is also observed at a mass unit which corresponds to the monomer (P). However, this appears to be an artifact, as is discussed below. It is obvious from this figure that a high-purity $P_2$ beam can be generated at a low temperature using tin phosphide. The partial vapor pressure of Sn was unmeasurable with our QMA, the maximum sensitivity of which is $1 \times 10^{-12}$ Torr.

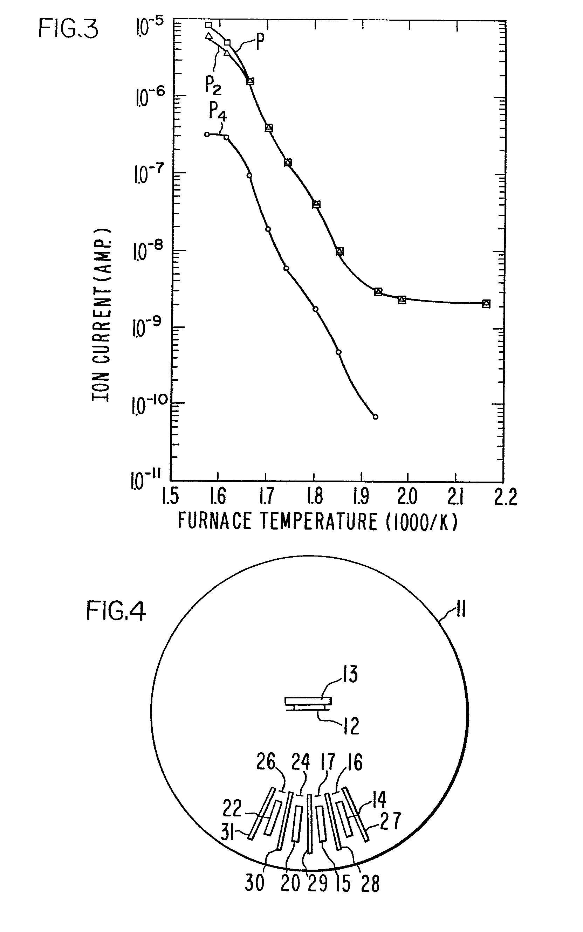

FIG. 3 shows the ion currents corresponding to P, $P_2$ and $P_4$ as a function of the temperature of the tin-phosphide furnace. As seen in the figure, the vapor pressure of $P_2$ increases about 3 orders of magnitude. The partial pressure of P exactly follows that of $P_2$. This leads me to believe that I do not generate P by this method, but that the mass spectrometer peak is an artifact due to the result of cracking $P_2$ in the mass spectrum analyzer head. Therefore, it was concluded that the beam consists of mostly $P_2$, with a small trace of $P_4$. The total pressure measured by QMA was $2-4 \times 10^{-5}$ Torr at 350°C, high enough for MBE growth. This data demonstrates the use of tin phosphide to produce a $P_2$ beam while eliminating the shortcomings of other phosphorus beam-generating methods such as generation of $P_4$, or unnecessary byproducts, making it a very attractive phosphorus source for InP MBE.

One particular apparatus embodiment for carrying out the invention is illustrated in FIG. 4. Numerical values stated in connection with this embodiment of the invention are illustrative only and are not intended to limit the scope of the invention. Semiconductor body 12, located within evacuable chamber 11, is affixed to molybdenum heating block 13 with indium (not shown). The effusion cells 14 and 15 for the group III elements may be of a construction known to those skilled in the art. (See, for example, Casey et al, U.S. Patent No. 3,974,002 for a description of a conventional effusion cell, or Cho, U S - A 4,239,955, for the description of an improved effusion cell, suitable for use in the present invention.) Illustratively, pyrolytic boron nitride crucibles may be used to contain the group III elements and the heated metal parts may comprise molybdenum or tantalum. The egress of the group III beams from effusion cells 14 and 15 is controlled by shutters 16 and 17. The group III effusion cell to substrate distances are about 12 cm. The group III beam intensities may be regulated by monitoring and varying the effusion cell temperatures. Nominal

0173448

effusion cell temperatures range from 900-1000°C for Ga, 1000-1300°C for Al and 800-840°C for In, depending on the effusion cell to substrate distance. Cryopanels 27, 28, 29, 30 and 31 are provided to reduce impurities.

The effusion cells 20 and 22 for the group V elements may be similar in form to those for the group III. At least one of these cells 20 and 22 is used for the tin phosphide. The shuttles 24 and 26 control the beams from the effusion cells 20 and 22.

This invention is not limited to the preferred embodiment heretofore described, to which variations and improvements may be made, without leaving the scope of protection of the present patent, the characteristics of which are summarized in the following claims.

## Claims

1.    A method of forming a III-V semiconductor layer by molecular beam deposition comprising the steps of:

directing a molecular beam, comprising at least one group III element, at a semiconductor body within an evacuated chamber;

simultaneously directing a molecular beam comprising at least one group V element at said semiconductor body, thereby forming said group III-V semiconductor layer; and the or a said group V molecular beam  being formed by decomposing a compound of tin and phosphorus with heat.

2.    An apparatus for forming a III-V semiconductor layer comprising:

an evacuable chamber;

first means coupled with said evacuable chamber for forming a Group III molecular beam;

second means coupled with said evacuable chamber for forming a Group V molecular beam;

said second means including

a compound of tin and phosphorous; and

means for decomposing said compound.

3.    An apparatus as in claim 2 wherein said compound of tin and phosphorous is SnP.

4.    An apparatus as in claim 2 where said compound of tin and phosphorus is $SnP_3$.

5.    An apparatus as in claim 2 where said compound of tin and phosphorus is $Sn_3P_4$.

6.    A method of using an MBE machine to make a III-V semiconductor layer on a substrate comprising:

0173448

- 12 -

inserting a group III element as a second source element;

activating said MBE machine to evacuate the space near said substrate and to decompose said sources and to direct molecules of said sources to the surface of said substrate.

7. The method of claim 1 or claim 6 wherein said group III element is indium.

8. The method of claim 1 or claim 6 wherein said group III element is gallium.

9. The method of claim 1 or claim 6 wherein said group III element is aluminum.

10. The method of claim 1 or claim 6 wherein said compound of tin and phosphorus is SnP.

11. The method of claim 1 or claim 6 wherein said compound of tin and phosphorus is $SnP_3$.

12. The method of claim 1 or claim 6 wherein said compound of tin and phosphorus is $Sn_3P_4$.

FIG.1

TEMPERATURE (°C)

FIG.2

$T(Sn-P) = 350°C$

0173448

2/2

FIG.3

ION CURRENT (AMP.)

FURNACE TEMPERATURE (1000/K)

FIG.4